# EUROPEAN PATENT SPECIFICATION

(11) **EP 4 355 043 B1**
(45) Date of publication and mention of the grant of the patent: **25.02.2026**
(21) Application number: 23186838.1
(22) Date of filing: 20.07.2023
(51) Int. Cl.: H05K 5/02, H05K 7/20

(54) **OUTDOOR ELECTRIC CABINET AND AIR DUCT STRUCTURE THEREOF**
AUSSENSTROMSCHRANK UND LUFTKANALSTRUKTUR DAFÜR
ARMOIRE ÉLECTRIQUE EXTÉRIEURE ET STRUCTURE DE CONDUIT D'AIR ASSOCIÉE

(30) Priority: 14.10.2022 CN 202211258997
(43) Date of publication of application: 17.04.2024
(73) Proprietor: Sungrow Hydrogen Sci.&Tech. Co., Ltd., Hefei 230088, Anhui (CN)
(72) Inventor: GE, Xiangwen, Hefei (CN); JIANG, Yuqin, Hefei (CN); GONG, Shengwei, Hefei (CN); ZHANG, Zhitong, Hefei (CN); CHEN, Erhao, Hefei (CN)
(74) Representative: Zacco Norway AS

(56) References cited:
- CN-A- 106 998 642
- JP-A- 2000 208 976

## Description

### FIELD

The present application relates to the technical field of electrical equipment, and in particular to an outdoor electric cabinet and an air duct structure thereof.

### BACKGROUND

The outdoor electric cabinet product has a very high power level, so a fan with large air volume, high wind pressure and high wind speed is required to be selected to be the cooling fan. A suction force at an air inlet port of the product is very large under normal operation, and protection of the whole machine can effectively protect large-volume solids. However, it is very difficult for protection against rainwater, especially in severe windy and stormy weather. When rainwater enters the air inlet port, it is directly sucked into the product by the high-speed fan and enters the inside of components. Therefore, the product running with electricity easily leads to failure or safety problems.

At present, the common means for realizing protection against water in bad weather is to reduce the suction force of the air inlet port by reducing the rotation speed of the fan. However, in many occasions, it is impossible to achieve full-power normal operation, and the safe operation of the outdoor electric cabinet in bad weather cannot be ensured.

In summary, the technical problem to be solved by those skilled in the art is that the outdoor electric cabinet cannot operate safely in bad weather.

JP2000208976A provides an outdoor housing comprises a main body 2. The main body 2 comprises an electronic device 5 and a battery 6, and a heat-intensive means 7 is installed at the upper edge of the body 2. This heat-intensive means 7 is formed in the quadrangular pyramid and is located at the upper part of the electronic device 5 and a ventilation port 9 is provided at the extreme end part thereof. A heat release means 8 having a square shape ceiling plate 10 and four side surfaces 11 is provided to cover the heat-intensive means 7. The heat release means 8 is provided with an outdoor-air port 12.

CN106998642A discloses a water prevention and heat dissipation integrated structure and a current collector. The water prevention and heat dissipation integrated structure comprises a heat dissipation passage and a separation chamber, wherein a separation assembly is arranged in the separation chamber and is connected with a fan, rainwater enters the separation chamber and is retained, air enters the heat dissipation passage through the separation chamber and by an effect of the fan, and the purposes of heat dissipation and water prevention can be integratedly achieved. The current collector is provided with the water prevention and heat dissipation integrated structure, wherein the heat dissipation passage is arranged at the bottom of a shell, the separation chamber is arranged at a side part, the air is guided to the heat dissipation passage by an air guide plate, a component in the heat is cooled, the heat dissipation efficiency can be improved, and the water prevention and heat dissipation integrated structure has relatively high integration.

### SUMMARY

The invention is set out in the appended set of claims. In view of this, an outdoor electric cabinet and an air duct structure thereof are provided according to the present application, so as to solve the problem that the outdoor electric cabinet cannot operate safely in bad weather.

In order to achieve the above object, the following technical solutions are provided as follows according to the present application.

An air duct structure of an outdoor electric cabinet, configured to guide airflow to an air inlet side of a fan is provided, including:
an air inlet port configured to introduce external airflow into the air duct structure;
a flow-guiding cavity formed between the air inlet port and the air inlet side of the fan; and
an air distribution assembly arranged in the flow-guiding cavity, to uniformly distribute an air suction force at the air inlet port.

In an embodiment, the air distribution assembly includes an air distribution cover arranged in the flow-guiding cavity and located at the air inlet side of the fan, multiple flow-introducing passages are provided on the air distribution cover, and the multiple flow-introducing passages are configured to introduce the airflow from the flow-guiding cavity to the air inlet side of the fan.

In an embodiment, the air distribution cover includes a fixed portion and multiple air tubes which are spaced apart on the fixed portion, and a through cavity defined in each of the multiple air tubes forms a corresponding one of the multiple flow-introducing passages.

In an embodiment, the multiple air tubes are uniformly arranged with equal heights; or, the multiple air tubes are arranged in a manner that heights of the air tubes are staggered along a preset direction; or, the multiple air tubes are arranged with heights being gradually decreased from a middle to two opposite sides of the fixed portion.

In an embodiment, the air distribution cover includes multiple partition plates, the partition plates are arranged in a staggered manner to define multiple partition passages, and the partition passages correspondingly form the multiple flow-introducing passages.

In an embodiment, the air distribution assembly further includes an air distribution plate which is arranged in the flow-guiding cavity, and the air distribution plate is located between the air inlet port and the air distribution cover.

In an embodiment, an air distribution cavity is formed between the air distribution cover and the air distribution plate in the flow-guiding cavity, the air distribution plate is configured to fragment and disperse the airflow from the air inlet port and introduce the airflow into the air distribution cavity, and the multiple flow-introducing passages are configured to introduce the airflow from the air distribution cavity to the air inlet side of the fan.

In an embodiment, a flow-guiding passage is formed at a position, corresponding to the air inlet port, of the flow-guiding cavity, and the flow-guiding passage is configured to guide the airflow from a position, corresponding to the air inlet port, in the flow-guiding cavity into the air distribution cavity.

In an embodiment, in a case that the air distribution cover includes a fixed portion and multiple air tubes which are spaced apart on the fixed portion, the flow-guiding passage includes a first flow-guiding passage configured to guide the airflow to an air inlet side of the air distribution plate and a second flow-guiding passage configured to guide the airflow to gaps between the multiple air tubes.

In an embodiment, a splash-proof plate configured for blocking rainwater is further provided at a position, corresponding to the air inlet port, in the flow-guiding cavity.

In an embodiment, a fan cover configured to introduce the airflow from the flow-guiding cavity into the fan is arranged at the air inlet side of the fan; an flow-guiding passage is defined by the splash-proof plate and an outer wall of the fan cover, and the flow-guiding passage is configured to guide the airflow from a position, corresponding to the air inlet port, in the flow-guiding cavity to the air distribution cavity.

In an embodiment, a surface of the outer wall of the fan cover and/or a surface of the splash-proof plate for forming the flow-guiding passage is provided with an absorption structure for reducing a wind speed.

In an embodiment, the number of the air inlet port is four, and the four air inlet ports are configured to be arranged on four side surfaces of the outdoor electric cabinet, respectively.

In an embodiment, the flow-guiding cavity has a high-speed airflow area and a low-speed airflow area; a flow-guiding plate is arranged at a position, corresponding to the air inlet port, of the flow-guiding cavity, and the flow-guiding plate is configured to guide the airflow in the high-speed airflow area into the low-speed airflow area.

Compared with the description in the background technology, the above air duct structure of the outdoor electric cabinet is configured to guide the airflow to the air inlet side of the fan. The air duct structure includes the air inlet port, the flow-guiding cavity and the air distribution assembly. The air inlet port is configured to introduce external airflow into the air duct structure; the flow-guiding cavity is formed between the air inlet port and the air inlet side of the fan; the air distribution assembly is arranged in the flow-guiding cavity to uniformly distribute the air suction force at the air inlet port. With the air duct structure, in practical application, since the air distribution assembly is provided in the flow-guiding cavity between the air inlet port and the air inlet side of the fan, the airflow suction force of the air inlet port is distributed more uniformly by the air distribution assembly, which effectively weakens the maximum wind speed on the shortest path, so that finally the suction force of the air inlet port on external water is uniform. Even in bad weather, the fan can still operate normally according to required power, so that the basic heat dissipation requirements of the outdoor electric cabinet are satisfied, and at the same time, the risk of external water inhalation caused by excessive suction force in local areas is avoided, thereby ensuring the safe operation of the outdoor electric cabinet.

In addition, an outdoor electric cabinet is further provided according to the present application, which includes the air duct structure according to any one of the above solutions. Since the air duct structure has the above technical effects, the outdoor electric cabinet including the air duct structure also has the above technical effects, which is not repeated herein.

### BRIEF DESCRIPTION OF THE DRAWINGS

For more clearly illustrating the technical solutions of embodiments of the present application or in the conventional technology, drawings referred to for describing the embodiments or the conventional technology will be briefly described hereinafter. Apparently, the drawings in the following description are only several examples of the present application, and for those skilled in the art, other drawings may be obtained based on these drawings without any creative efforts.
FIG. 1 is a schematic perspective view showing an air duct structure according to an embodiment of the present application, where a housing of an outdoor electric cabinet is omitted in the figure;
FIG. 2 is a schematic top view of the air duct structure according to the embodiment of the present application, where the housing of the outdoor electric cabinet is omitted in the figure;
FIG. 3 is an internal cross-sectional schematic view of the air duct structure according to the embodiment of the present application;
FIG. 4 is a schematic view showing an airflow direction inside the air duct structure (arrows in the figure represents the airflow direction) according to the embodiment of the present application;
FIG. 5 is a schematic perspective view showing the structure of an air distribution cover in a first structural form according to an embodiment of the present application;
FIG. 6 is a schematic top view of the air distribution cover in the first structural form according to the embodiment of the present application;
FIG. 7 is a schematic perspective view showing the structure of an air distribution cover in a second structural form according to an embodiment of the present application;
FIG. 8 is a schematic perspective view showing the structure of an air distribution cover in a third structural form according to an embodiment of the present application;
FIG. 9 is a schematic perspective view showing the structure of an air distribution cover in a fourth structural form according to an embodiment of the present application;
FIG. 10 is a schematic top view showing the structure of an air distribution cover in a fifth structural form according to an embodiment of the present application;
FIG. 11 is a schematic top view showing the structure of an air distribution cover in a sixth structural form according to an embodiment of the present application;
FIG. 12 is a schematic top view showing the structure of an air distribution cover in a seventh structural form according to an embodiment of the present application; and
FIG. 13 is a schematic top view showing the structure of an air distribution cover in an eighth structural form according to an embodiment of the present application.

### Reference numerals:

| | | | |
|---|---|---|---|
| 1 | fan; | 2 | fan cover, |
| 21 | airflow inlet end, | 22 | airflow outlet end, |
| 3 | air inlet port, | 4 | flow-guiding cavity, |
| 40 | air distribution cavity, | 41 | flow-guiding passage, |
| 410 | first flow-guiding passage, | 411 | second flow-guiding passage, |
| 42 | flow-guiding plate, | 5 | air distribution assembly, |
| 51 | air distribution cover, | 510 | flow-introducing passage, |
| 511 | fixed portion, | 512 | air tube, |
| 513 | partition plate, | 514 | gap, |
| 52 | air distribution plate, | 6 | splash-proof plate, |
| 7 | outdoor electric cabinet, | 8 | absorption structure. |

### DETAILED DESCRIPTION OF THE EMBODIMENTS

An object of the present application is to provide an outdoor electric cabinet and an air duct structure thereof, to solve the problem that the outdoor electric cabinet cannot operate safely in bad weather.

Technical solutions in the embodiments of the present invention are clearly and completely described hereinafter in conjunction with the drawings in the embodiments of the present application. Apparently, the embodiments described in the following are only some embodiments of the present application, rather than all embodiments. Based on the embodiments in the present application, all of the other embodiments which are obtained by those skilled in the art without any creative work fall within the protection scope of the present application.

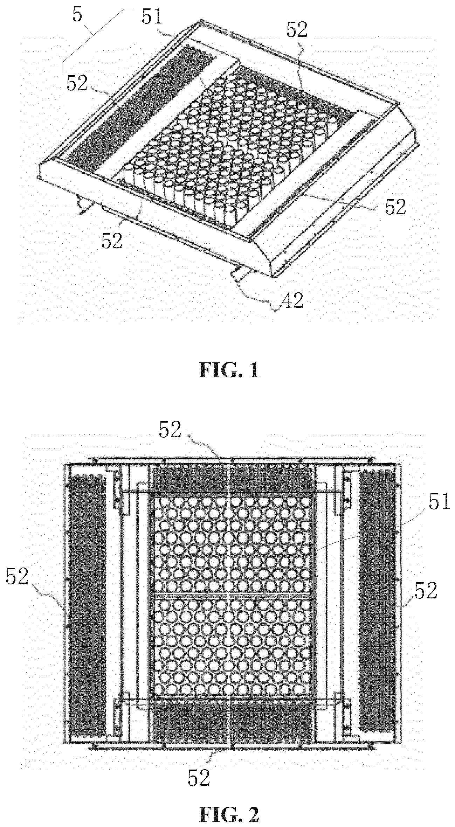

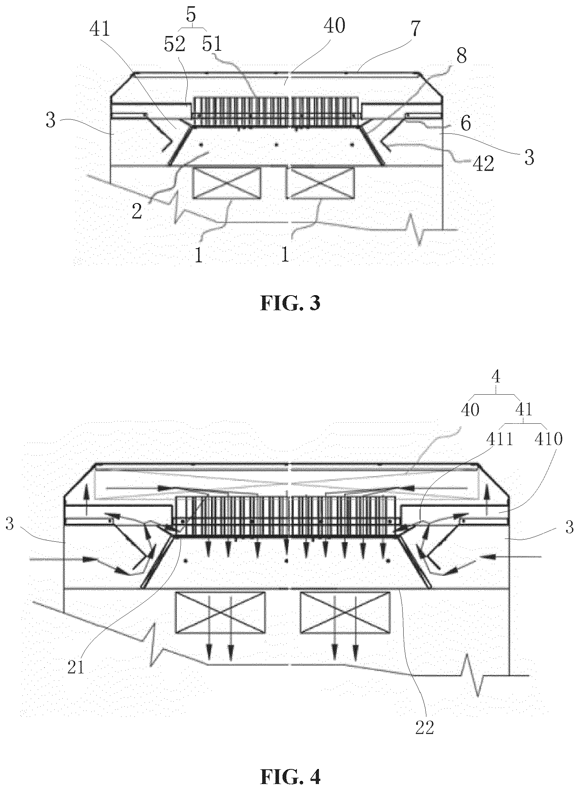

An air duct structure of an outdoor electric cabinet is specifically provided according to the present application, as shown in FIG. 1 to FIG. 4, the air duct structure is specifically configured to guide airflow to an air inlet side of a fan. The air duct structure specifically includes an air inlet port 3, a flow-guiding cavity 4 and an air distribution assembly 5. The air inlet port 3 is configured to introduce external airflow into the air duct structure. The flow-guiding cavity 4 is formed between the air inlet port 3 and the air inlet side of the fan 1. The air distribution assembly 5 is arranged in the flow-guiding cavity 4 to uniformly distribute an air suction force at the air inlet port 3.

With the air duct structure, in practical application, since the air distribution assembly 5 is provided in the flow-guiding cavity 4 between the air inlet port 3 and the air inlet side of the fan 1, the airflow suction force of the air inlet port 3 is distributed more uniformly by the air distribution assembly 5, which effectively weakens the maximum wind speed on the shortest path, so that finally the suction force of the air inlet port 3 on external water is uniform. Even in bad weather, the fan 1 can still operate normally according to required power, so that the basic heat dissipation requirements of the outdoor electric cabinet 7 are satisfied, and at the same time, the risk of external water inhalation caused by excessive suction force in local areas is avoided, thereby ensuring the safe operation of the outdoor electric cabinet 7.

It should be understood by those skilled in the art that the air duct structure is arranged inside a housing of the outdoor electric cabinet 7, and the air inlet port 3 is defined on the housing of the outdoor electric cabinet, for example, it may be defined on a side surface of the outdoor electric cabinet 7 or at other positions of the outdoor electric cabinet 7, and the arrangement may be performed according to actual needs in practical application. In the working process, the fan 1 is configured to operate normally to introduce external airflow into the air duct structure, and send the airflow to positions in the housing of the outdoor electric cabinet 7 where heat dissipation is needed through an air outlet side of the fan 1, so as to realize the basic heat dissipation requirement of internal components.

It should be further noted that, an air inlet area of the fan 1 itself is fixed, so the wind speed and wind pressure in this small area are very high. The air inlet port 3, the flow-guiding cavity 4, the air distribution assembly 5 and the fan 1 can form a whole, to subdivide, disperse and fragment the airflow path by the air distribution assembly 5, so as to realize an increased and uniform air inlet area.

In some specific embodiments, the air distribution assembly 5 specifically includes an air distribution cover 51 arranged in the flow-guiding cavity 4 and located at the air inlet side of the fan 1, multiple flow-introducing passages 510 are provided on the air distribution cover 51, and the multiple flow-introducing passages 510 are configured to introduce the airflow in the flow-guiding cavity 4 to the air inlet side of the fan 1. With the air distribution assembly 5 being designed to have the structure of the air distribution cover 51, the space at the air inlet side of the fan 1 can be subdivided and fragmented by the flow-introducing passages 510, so that the air suction path of the fan 1 is better dispersed, which is beneficial to achieving the uniform suction force.

In a further embodiment, the air distribution cover 51 specifically includes a fixed portion 511 and multiple air tubes 512 spaced apart on the fixed portion 511, and through cavities of the multiple air tubes 512 form the multiple flow-introducing passages 510 respectively. With the above structure, the arrangement of the flow-introducing passages 510 is more convenient and easy to realize in structure. In addition, with the integral air tube structure in the airflow path, the noise of the whole machine can be effectively reduced.

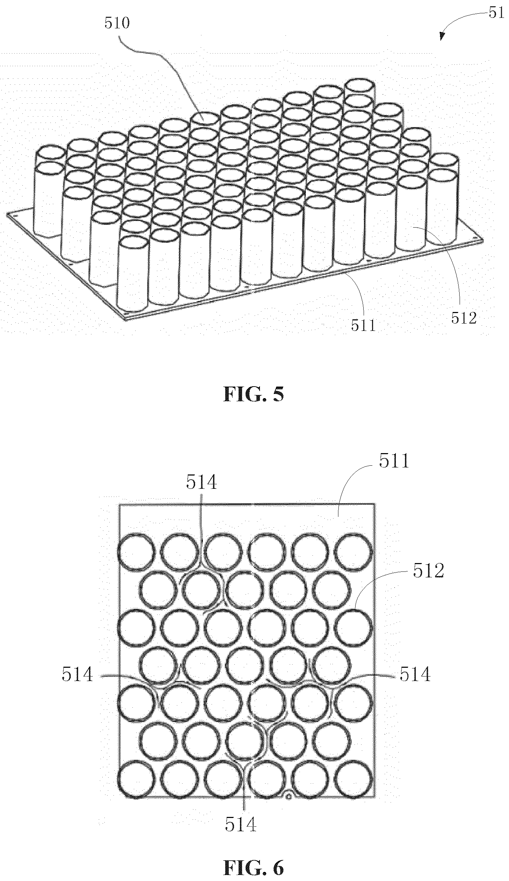

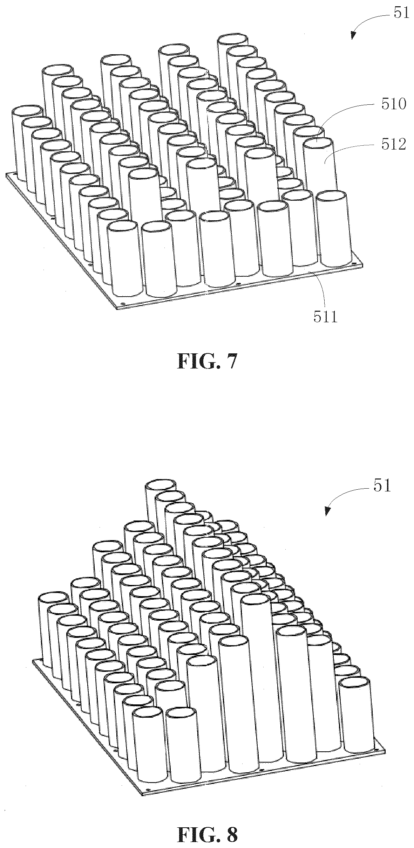

In a further embodiment, the multiple air tubes 512 may be uniformly arranged with equal heights, as shown in FIG. 5 and FIG. 6. Or, the heights of the air tubes 512 may be flexibly changed, so that the independent air tubes can form their own small air passages; as the number of the air tubes 512 increases and the height of the air tubes increases, the formed wind resistance is more uniform, and thus the uniform ventilation effect is finally realized. For example, the multiple air tubes 512 may be arranged in a manner that heights of the air tubes are staggered along a preset direction as shown in FIG. 7; alternatively, the multiple air tubes 512 may be arranged with heights being gradually decreased from a middle towards two opposite sides of the fixed portion 511. As long as the air distribution cover 51 has independent small air passages formed by subdividing, the purpose of dispersion, subdivision and fragmentation of the airflow can be achieved. In practical application, the arrangement can be performed according to the actual needs, which is not specifically limited herein.

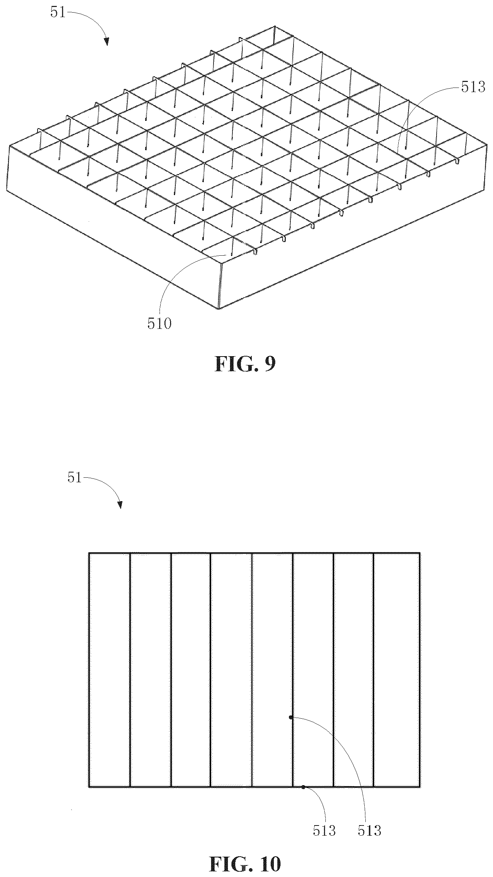

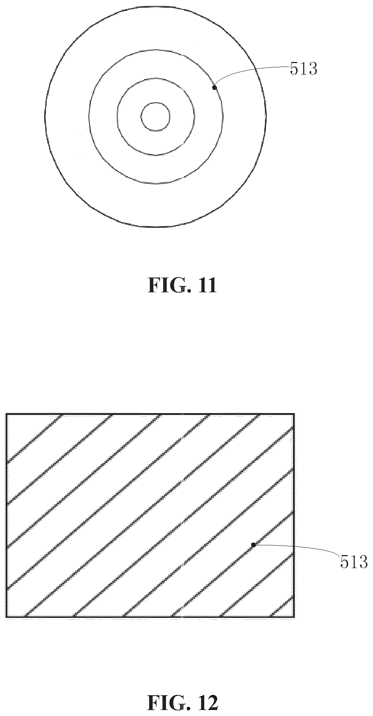

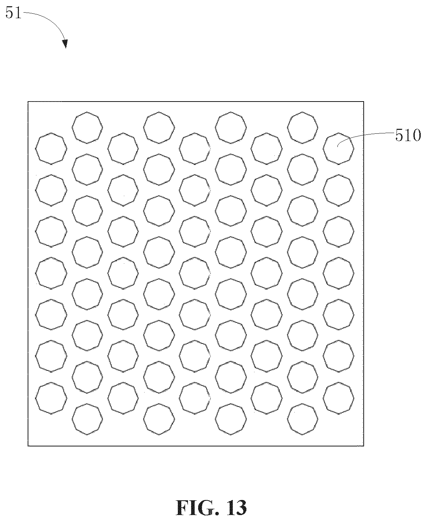

It should be noted that the air distribution cover 51 employing the structural form of the fixed portion 511 and the air tubes 512 is only an example of the embodiments of the present application. In practical application, the air distribution cover 51 may be designed into other structural forms. For example, the air distribution cover 51 may be designed to include multiple partition plates 513, the partition plates 513 are arranged in a staggered manner to define multiple partition passages, and the multiple partition passages correspondingly form the multiple flow-introducing passages 510. That is, the minimum partition passages defined by the multiple partition plates 513 form the multiple flow-introducing passages 510. The specific structural form may be referred to FIG. 9. Of course, the air distribution cover 51 may be designed to have strip-shaped flow-introducing passages arranged sequentially in the preset direction as shown in FIG. 10; or, be designed to have concentric circular flow-introducing passages as shown in FIG. 11; or, be designed to have strip-shaped inclined flow-introducing passages arranged sequentially as shown in FIG. 12; or, be designed to have a perforated plate, where the shape of the holes may be configured according to actual needs, such as polygonal holes as shown in FIG. 13. As long as the airflow can be subdivided, dispersed, and fragmented, the specific structure is not limited.

In some further embodiments, the air distribution assembly 5 further includes an air distribution plate 52 which is arranged in the flow-guiding cavity 4, and the air distribution plate 52 is located between the air inlet port 3 and the air distribution cover 51. With the above structural form of the air distribution assembly 5, the airflow flowing through the air distribution plate 52 can be subdivided, dispersed, and fragmented, that is, the suction force of the air inlet side of the air distribution plate 52 is more uniform, which is more beneficial to uniformly distribution of the suction force of the air inlet port 3. The specific structure of the air distribution plate 52 may be a perforated plate structure or a mesh structure. In practical application, the structure can be selected according to the actual needs, as long as the airflow can be subdivided, dispersed and fragmented, and no more specific limitations are made here.

In a further embodiment, an air distribution cavity 40 is formed between the air distribution cover 51 and the air distribution plate 52 in the flow-guiding cavity 4, the air distribution plate 52 is configured to fragment and disperse the airflow from the air inlet port 3 and introduce the airflow into the air distribution cavity 40, and the multiple flow-introducing passages 510 are configured to introduce the airflow from the air distribution cavity 40 to the air inlet side of the fan 1. In the above structure, a buffer space of the airflow is formed with the air distribution cavity 40, which ensures the air suction volume of the fan 1 under normal operation, and at the same time ensures the uniform distribution of the airflow suction force at the air inlet port 3, and thereby effectively reducing the risk of external water inhalation caused by excessive local suction force of the air inlet port 3.

It should be noted that the air distribution plate 52 may be specifically designed to be arranged around the air distribution cover 51, for example, multiple air distribution plates 52 are arranged to surround the air distribution cover 51. After the airflow passing through the air distribution plates 52 in multiple directions, a constant pressure area is formed downstream of the air distribution plate 52 (that is, in the air distribution cavity 40), which can basically maintain uniform wind speed in all directions.

In a further embodiment, a flow-guiding passage 41 is formed at a position, corresponding to the air inlet port 3, of the flow-guiding cavity 4, and the flow-guiding passage 41 is configured to guide the airflow from a position, corresponding to the air inlet port 3, in the flow-guiding cavity 4 to the air distribution cavity 40. With the flow-guiding passage 41, the airflow is introduced more smoothly, and the formation of a local air duct dead zone is avoided.

In a further embodiment, in a case that the air distribution assembly 5 includes the air distribution cover 51 and the air distribution plate 52, and the air distribution cover includes a fixed portion 511 and multiple air tubes 512 which are spaced apart on the fixed portion 511, the flow-guiding passage 41 includes a first flow-guiding passage 410 configured to guide the airflow to an air inlet side of the air distribution plate 52 and a second flow-guiding passage 411 configured to guide the airflow to gaps 514 between the multiple air tubes 512. With the structural form of the first flow-guiding passage 410 and the second flow-guiding passage 411 of the flow-guiding passage 41, the airflow in the flow-guiding passage 41 is divided into two streams. The first stream of airflow enters the air distribution plate 52 through the first flow-guiding passage 410, then enters the air distribution cavity 40, and is sucked into the air inlet side of the fan 1 by the air distribution cover 51. The second stream of airflow enters the gaps 514 between the multiple air tubes 512 of the air distribution cover 51 through the second flow-guiding passage 411, gathers in the air distribution cavity 40 and enters the air inlet side of the fan 1 through the flow-introducing passages 510 of the air tubes 512. Through the gaps 514 between the multiple air tubes 512, the wind force can be dispersed more uniformly, and the air distribution effect at the middle portion of the air tubes 512 is better. In this process, the airflow introduced by the flow-guiding passage 41 is divided and then gathered in the air distribution cavity 40, which is beneficial to reducing the difference between a high-speed airflow area and a low-speed airflow area, that is, the suction force can be distributed more uniformly at the air inlet port 3 under the operation of the fan 1.

In some embodiments, a splash-proof plate 6 configured for blocking rainwater is further provided at a position, corresponding to the air inlet port 3, in the flow-guiding cavity 4. With the splash-proof plate 6, external water (such as rainwater) can be effectively prevented from entering the fan 1, and thus the waterproofing performance is improved. Besides, the airflow can be introduced to the air distribution cavity 40, to be buffered at the air distribution cavity 40, and an air distribution area is formed.

In a further embodiment, a fan cover 2 configured to introduce the airflow from the flow-guiding cavity 4 into the fan 1 is arranged at the air inlet side of the fan 1, a flow-guiding passage 41 is defined by the splash-proof plate 6 and an outer wall of the fan cover 2, and the flow-guiding passage 41 is configured to guide the airflow from a position, corresponding to the air inlet port 3, in the flow-guiding cavity 4 to the air distribution cavity 40. With the fan cover 2, on one hand, air suction on the air inlet side of the fan 1 is more stable and reliable, and the air inlet cross-sectional area of the air inlet side is increased, which makes the air inlet area increased and more uniform; one the other hand, the fan cover 2 facilitates the formation of the flow-guiding passage 41. Specifically, the fan cover 2 may include an airflow inlet end 21 and an airflow outlet end 22. The airflow inlet end 21 is configured to be in communication with the air distribution assembly 5, for example, being in communication with an air outlet side of the air distribution cover 51, and the airflow outlet end 22 is arranged to be opposite to the air inlet side of the fan 1.

In a further embodiment, a surface of the outer wall of the fan cover 2 for forming the flow-guiding passage 41 may be provided with an absorption structure 8. Similarly, a surface of the splash-proof plate 6 for forming the flow-guiding passage 41 may also be provided with an absorption structure 8. With the absorption structure 8, since the absorption structure is made of an absorption material, the roughness characteristic of the absorption material can directly reduce the surface wind speed of the splash-proof plate and the fan cover, and the risk of suction of fine water droplets on surfaces of these structural members can also be reduced. The absorption structure 8 may be specifically made of a soft material with certain clearances, such as gauze, sponge or the like.

In some embodiments, the number of the air inlet port 3 may be one or more, and the specific number is selected according to actual needs. For example, the specific number of the air inlet port may be four, and the four air inlet ports are respectively arranged on four side surfaces of the outdoor electric cabinet 7. With the above arrangement, air is introduced from four surfaces, which increases the air inlet cross-sectional area, and the air inlet wind speed is effectively reduced while ensuring the air inlet volume.

In some specific embodiments, the flow-guiding cavity 4 generally includes a high-speed airflow area and a low-speed airflow area, a flow-guiding plate 42 is arranged at a position, corresponding to the air inlet port 3, of the flow-guiding cavity 4, and the flow-guiding plate 42 is configured to guide the airflow in the high-speed airflow area into the low-speed airflow area. For example, when the air inlet ports 3 are distributed on a left side and a right side of the outdoor electric cabinet, an area where the two air inlet ports 3 are located is the high-speed airflow area (with relatively short airflow path), and a front side and a rear side of the outdoor electric cabinet are the low-speed airflow area (with relatively long airflow path). With the flow-guiding plate 42 being arranged at each of the air inlet ports 3 on the left side and the right side, the airflow in the high-speed airflow area can be guided to the low-speed airflow area, thereby reducing the airflow speed in the high-speed airflow area. It should be noted that the flow-guiding plate 42 may be arranged at a position with a relatively large difference according to a difference of the air distribution areas in the simulation test, so as to reduce the airflow speed in the high-speed airflow area.

Further, an outdoor electric cabinet is further provided according to the present application, which includes the air duct structure according to any one of the above solutions. Since the air duct structure has the above technical effects, the outdoor electric cabinet including the air duct structure also has the above technical effects, which is not repeated herein.

## Claims

1. An air duct structure applicable to an outdoor electric cabinet, configured to guide airflow to an air inlet side of a fan (1), comprising:
an air inlet port (3) configured to introduce external airflow into the air duct structure;
a flow-guiding cavity (4) configured to be formed between the air inlet port (3) and the air inlet side of the fan (1); and
an air distribution assembly (5) arranged in the flow-guiding cavity (4) and configured to uniformly distribute an air suction force at the air inlet port (3); wherein
the air distribution assembly (5) comprises an air distribution cover (51) which is arranged in the flow-guiding cavity (4) and is located at the air inlet side of the fan (1), and an air distribution plate (52) which is arranged in the flow-guiding cavity (4); wherein
a plurality of flow-introducing passages (510) are provided on the air distribution cover (51), and the plurality of flow-introducing passages (510) are configured to introduce the airflow from the flow-guiding cavity (4) to the air inlet side of the fan (1);
the air distribution plate (52) is located between the air inlet port (3) and the air distribution cover (51); and
an air distribution cavity (40) is formed between the air distribution cover (51) and the air distribution plate (52) in the flow-guiding cavity (4), the air distribution plate (52) is configured to fragment and disperse the airflow from the air inlet port (3) and introduce the airflow into the air distribution cavity (40), and the plurality of flow-introducing passages (510) are configured to introduce the airflow from the air distribution cavity (40) to the air inlet side of the fan (1).

2. The air duct structure according to claim 1, wherein the air distribution cover (51) comprises a fixed portion (511) and a plurality of air tubes (512) which are spaced apart on the fixed portion (511), and wherein a through cavity defined in each of the plurality of air tubes (512) forms a corresponding one of the plurality of flow-introducing passages (510).

3. The air duct structure according to claim 2, wherein
the plurality of air tubes (512) are uniformly arranged with equal heights; or,
the plurality of air tubes (512) are arranged in a manner that heights of the air tubes (512) are staggered along a preset direction; or,
the plurality of air tubes (512) are arranged with heights being decreased from a middle towards two opposite sides of the fixed portion (511).

4. The air duct structure according to claim 1, wherein the air distribution cover (51) comprises a plurality of partition plates (513), the partition plates (513) are arranged in a staggered manner to define a plurality of partition passages, and the plurality of partition passages correspondingly form the plurality of flow-introducing passages (510).

5. The air duct structure according to claim 1, wherein a flow-guiding passage (41) is formed at a position, corresponding to the air inlet port (3), of the flow-guiding cavity (4), and the flow-guiding passage (41) is configured to guide the airflow from a position, corresponding to the air inlet port (3), in the flow-guiding cavity (4) to the air distribution cavity (40).

6. The air duct structure according to claim 5, wherein in a case that the air distribution cover (51) comprises a fixed portion (511) and a plurality of air tubes (512) which are spaced apart on the fixed portion (511), the flow-guiding passage (41) comprises a first flow-guiding passage (410) configured to guide the airflow to an air inlet side of the air distribution plate (52) and a second flow-guiding passage (411) configured to guide the airflow to gaps between the plurality of air tubes (512).

7. The air duct structure according to claim 1, wherein a splash-proof plate (6) configured for blocking rainwater is further provided at a position, corresponding to the air inlet port (3), in the flow-guiding cavity (4).

8. The air duct structure according to claim 7, wherein a fan cover (2) configured to introduce the airflow from the flow-guiding cavity (4) into the fan (1) is arranged at the air inlet side of the fan (1); and wherein an flow-guiding passage (41) is defined by the splash-proof plate (6) and an outer wall of the fan cover (2), and the flow-guiding passage (41) is configured to guide the airflow from a position, corresponding to the air inlet port (3), in the flow-guiding cavity (4) to the air distribution cavity (40).

9. The air duct structure according to claim 8, wherein a surface of the outer wall of the fan cover (2) and/or a surface of the splash-proof plate (6) for forming the flow-guiding passage (41) is provided with an absorption structure (8) for reducing a wind speed.

10. The air duct structure according to claim 1, wherein the number of the air inlet port (3) is four, and the four air inlet ports (3) are configured to be arranged on four side surfaces of the outdoor electric cabinet (7), respectively.

11. The air duct structure according to claim 1, wherein the flow-guiding cavity (4) has a high-speed airflow area and a low-speed airflow area; a flow-guiding plate (42) is arranged at a position, corresponding to the air inlet port (3), of the flow-guiding cavity (4), and the flow-guiding plate (42) is configured to guide the airflow in the high-speed airflow area into the low-speed airflow area.

12. An outdoor electric cabinet, comprising an air duct structure, wherein the air duct structure is the air duct structure according to any one of claims 1 to 11.

## Patentansprüche

1. Luftkanalstruktur, die bei einem Außenstromschrank anwendbar und so konfiguriert ist, dass sie einen Luftstrom zu einer Lufteinlassseite eines Lüfters (1) leitet, umfassend:
eine Lufteinlassöffnung (3), die so konfiguriert ist, dass ein externer Luftstrom in die Luftkanalstruktur geleitet wird;
einen strömungsleitenden Hohlraum (4), der so konfiguriert ist, dass er zwischen der Lufteinlassöffnung (3) und der Lufteinlassseite des Lüfters (1) gebildet wird; und
eine Luftverteilerbaugruppe (5), die in dem strömungsleitenden Hohlraum (4) angeordnet und so konfiguriert ist, dass sie eine Luftansaugkraft an der Lufteinlassöffnung (3) gleichmäßig verteilt; wobei
die Luftverteilerbaugruppe (5) eine Luftverteilerabdeckung (51) umfasst, die in dem strömungsleitenden Hohlraum (4) angeordnet ist und sich an der Lufteinlassseite des Lüfters (1) befindet, und eine Luftverteilerplatte (52) umfasst, die in dem strömungsleitenden Hohlraum (4) angeordnet ist; wobei
eine Mehrzahl von strömungseinbringenden Durchlässen (510) auf der Luftverteilerabdeckung (51) vorgesehen ist und die Mehrzahl von strömungseinbringenden Durchlässen (510) so konfiguriert ist, dass der Luftstrom aus dem strömungsleitenden Hohlraum (4) zur Lufteinlassseite des Lüfters (1) eingebracht wird;
die Luftverteilerplatte (52) zwischen der Lufteinlassöffnung (3) und der Luftverteilerabdeckung (51) angeordnet ist; und
zwischen der Luftverteilerabdeckung (51) und der Luftverteilerplatte (52) im strömungsleitenden Hohlraum (4) ein Luftverteilerhohlraum (40) gebildet ist, wobei die Luftverteilerplatte (52) so konfiguriert ist, dass sie den Luftstrom aus der Lufteinlassöffnung (3) zerlegt und zerstreut und den Luftstrom in den Luftverteilerhohlraum (40) einbringt, und die Mehrzahl von strömungseinbringenden Durchlässen (510) so konfiguriert ist, dass der Luftstrom aus dem Luftverteilerhohlraum (40) zur Lufteinlassseite des Lüfters (1) eingebracht wird.

2. Luftkanalstruktur nach Anspruch 1, wobei die Luftverteilerabdeckung (51) einen festen Abschnitt (511) und eine Mehrzahl von Luftrohren (512) umfasst, die auf dem festen Abschnitt (511) beabstandet sind, und wobei ein Durchgangshohlraum, der in jedem der Mehrzahl von Luftrohren (512) definiert ist, einen entsprechenden der Mehrzahl von strömungseinbringenden Durchlässen (510) bildet.

3. Luftkanalstruktur nach Anspruch 2, wobei
die Mehrzahl von Luftrohren (512) gleichmäßig mit gleichen Höhen angeordnet ist; oder
die Mehrzahl von Luftrohren (512) so angeordnet ist, dass Höhen der Luftrohre (512) entlang einer voreingestellten Richtung versetzt sind; oder
die Mehrzahl von Luftrohren (512) mit Höhen angeordnet ist, die von einer Mitte hin zu zwei gegenüberliegenden Seiten des festen Abschnitts (511) abnehmen.

4. Luftkanalstruktur nach Anspruch 1, wobei die Luftverteilerabdeckung (51) eine Mehrzahl von Trennplatten (513) umfasst, wobei die Trennplatten (513) versetzt angeordnet sind, um eine Mehrzahl von Trenndurchlässen zu definieren, und die Mehrzahl von Trenndurchlässen die Mehrzahl von strömungseinbringenden Durchlässen (510) entsprechend bildet.

5. Luftkanalstruktur nach Anspruch 1, wobei ein strömungsleitender Durchlass (41) an einer der Lufteinlassöffnung (3) entsprechenden Position des strömungsleitenden Hohlraums (4) ausgebildet ist und der strömungsleitende Durchlass (41) so konfiguriert ist, dass er den Luftstrom von einer der Lufteinlassöffnung (3) entsprechenden Position in dem strömungsleitenden Hohlraum (4) zum Luftverteilungshohlraum (40) leitet.

6. Luftkanalstruktur nach Anspruch 5, wobei, wenn die Luftverteilerabdeckung (51) einen festen Abschnitt (511) und eine Mehrzahl von Luftrohren (512) umfasst, die auf dem festen Abschnitt (511) beabstandet sind, der strömungsleitende Durchlass (41) einen ersten strömungsleitenden Durchlass (410), der so konfiguriert ist, dass er den Luftstrom zu einer Lufteinlassseite der Luftverteilungsplatte (52) leitet, und einen zweiten strömungsleitenden Durchlass (411), der so konfiguriert ist, dass er den Luftstrom zu Lücken zwischen der Mehrzahl von Luftrohren (512) leitet, umfasst.

7. Luftkanalstruktur nach Anspruch 1, wobei eine spritzwassergeschützte Platte (6), die zum Blockieren von Regenwasser konfiguriert ist, ferner an einer Position in dem strömungsleitenden Hohlraum (4) vorgesehen ist, die der Lufteinlassöffnung (3) entspricht.

8. Luftkanalstruktur nach Anspruch 7, wobei eine Lüfterabdeckung (2), die so konfiguriert ist, dass sie den Luftstrom aus dem strömungsleitenden Hohlraum (4) in den Lüfter (1) leitet, an der Lufteinlassseite des Lüfters (1) angeordnet ist; und wobei ein strömungsleitender Durchlass (41) durch die spritzwassergeschützte Platte (6) und eine Außenwand der Lüfterabdeckung (2) definiert ist und der strömungsleitende Durchlass (41) so konfiguriert ist, dass er den Luftstrom von einer der Lufteinlassöffnung (3) entsprechenden Position in dem strömungsleitenden Hohlraum (4) zum Luftverteilerhohlraum (40) leitet.

9. Luftkanalstruktur nach Anspruch 8, wobei eine Oberfläche der Außenwand der Lüfterabdeckung (2) und/oder eine Oberfläche der spritzwassergeschützten Platte (6) zum Ausbilden des strömungsleitenden Durchlasses (41) mit einer Absorptionsstruktur (8) zur Reduzierung einer Windgeschwindigkeit versehen ist.

10. Luftkanalstruktur nach Anspruch 1, wobei die Anzahl der Lufteinlassöffnung (3) vier ist und die vier Lufteinlassöffnungen (3) so konfiguriert sind, dass sie auf vier Seitenflächen des Außenstromschranks (7) anzuordnen sind.

11. Luftkanalstruktur nach Anspruch 1, wobei der strömungsleitende Hohlraum (4) einen Hochgeschwindigkeits-Luftstrombereich und einen Niedergeschwindigkeits-Luftstrombereich aufweist; eine strömungsleitende Platte (42) in einer der Lufteinlassöffnung (3) entsprechenden Position des strömungsleitenden Hohlraums (4) angeordnet ist und die strömungsleitende Platte (42) so konfiguriert ist, dass sie den Luftstrom im Hochgeschwindigkeits-Luftstrombereich in den Niedergeschwindigkeits-Luftstrombereich leitet.

12. Außenstromschrank, der eine Luftkanalstruktur umfasst, wobei die Luftkanalstruktur die Luftkanalstruktur nach einem der Ansprüche 1 bis 11 ist.

## Revendications

1. Structure de conduit d'air applicable à une armoire électrique extérieure, configurée pour guider un flux d'air vers un côté d'entrée d'air d'un ventilateur (1), comprenant :
un orifice d'entrée d'air (3) configuré pour introduire un flux d'air externe dans la structure de conduit d'air ;
une cavité de guidage de flux (4) configurée pour être formée entre l'orifice d'entrée d'air (3) et le côté d'entrée d'air du ventilateur (1) ; et
un ensemble de distribution d'air (5) disposé dans la cavité de guidage de flux (4) et configuré pour distribuer uniformément une force d'aspiration d'air au niveau de l'orifice d'entrée d'air (3) ; dans laquelle
l'ensemble de distribution d'air (5) comprend un couvercle de distribution d'air (51) qui est disposé dans la cavité de guidage de flux (4) et est situé au niveau du côté d'entrée d'air du ventilateur (1), et une plaque de distribution d'air (52) qui est disposée dans la cavité de guidage de flux (4) ; dans laquelle
une pluralité de passages d'introduction de flux (510) sont prévus sur le couvercle de distribution d'air (51), et la pluralité de passages d'introduction de flux (510) sont configurés pour introduire le flux d'air provenant de la cavité de guidage de flux (4) vers le côté d'entrée d'air du ventilateur (1) ;
la plaque de distribution d'air (52) est située entre l'orifice d'entrée d'air (3) et le couvercle de distribution d'air (51) ; et
une cavité de distribution d'air (40) est formée entre le couvercle de distribution d'air (51) et la plaque de distribution d'air (52) dans la cavité de guidage de flux (4), la plaque de distribution d'air (52) est configurée pour fragmenter et disperser le flux d'air à partir de l'orifice d'entrée d'air (3) et introduire le flux d'air dans la cavité de distribution d'air (40), et la pluralité de passages d'introduction de flux (510) sont configurés pour introduire le flux d'air provenant de la cavité de distribution d'air (40) vers le côté d'entrée d'air du ventilateur (1).

2. Structure de conduit d'air selon la revendication 1, dans laquelle le couvercle de distribution d'air (51) comprend une partie fixe (511) et une pluralité de tubes d'air (512) qui sont espacés sur la partie fixe (511), et dans laquelle une cavité traversante définie dans chacun de la pluralité de tubes d'air (512) forme un passage correspondant de la pluralité de passages d'introduction de flux (510).

3. Structure de conduit d'air selon la revendication 2, dans laquelle
la pluralité de tubes d'air (512) sont disposés uniformément avec des hauteurs égales ; ou,
la pluralité de tubes d'air (512) sont disposés de manière à ce que les hauteurs des tubes d'air (512) soient décalées le long d'une direction prédéfinie ; ou,
la pluralité de tubes d'air (512) sont disposés avec des hauteurs diminuant à partir d'un milieu vers deux côtés opposés de la partie fixe (511).

4. Structure de conduit d'air selon la revendication 1, dans laquelle le couvercle de distribution d'air (51) comprend une pluralité de plaques de séparation (513), les plaques de séparation (513) sont disposées de manière décalée pour définir une pluralité de passages de séparation, et la pluralité de passages de séparation forment de manière correspondante la pluralité de passages d'introduction de flux (510).

5. Structure de conduit d'air selon la revendication 1, dans laquelle un passage de guidage de flux (41) est formé à une position, correspondant à l'orifice d'entrée d'air (3), de la cavité de guidage de flux (4), et le passage de guidage de flux (41) est configuré pour guider le flux d'air à partir d'une position, correspondant à l'orifice d'entrée d'air (3), dans la cavité de guidage de flux (4) vers la cavité de distribution d'air (40).

6. Structure de conduit d'air selon la revendication 5, dans laquelle dans un cas où le couvercle de distribution d'air (51) comprend une partie fixe (511) et une pluralité de tubes d'air (512) qui sont espacés sur la partie fixe (511), le passage de guidage de flux (41) comprend un premier passage de guidage de flux (410) configuré pour guider le flux d'air vers un côté d'entrée d'air de la plaque de distribution d'air (52) et un second passage de guidage de flux (411) configuré pour guider le flux d'air vers des espaces entre la pluralité de tubes d'air (512).

7. Structure de conduit d'air selon la revendication 1, dans laquelle une plaque pare-éclaboussures (6) configurée pour bloquer l'eau de pluie est en outre prévue à une position, correspondant à l'orifice d'entrée d'air (3), dans la cavité de guidage de flux (4).

8. Structure de conduit d'air selon la revendication 7, dans laquelle un capot de ventilateur (2) configuré pour introduire le flux d'air provenant de la cavité de guidage de flux (4) dans le ventilateur (1) est disposé au niveau du côté d'entrée d'air du ventilateur (1) ; et dans laquelle un passage de guidage de flux (41) est défini par la plaque pare-éclaboussures (6) et une paroi externe du capot de ventilateur (2), et le passage de guidage de flux (41) est configuré pour guider le flux d'air à partir d'une position, correspondant à l'orifice d'entrée d'air (3), dans la cavité de guidage de flux (4) vers la cavité de distribution d'air (40).

9. Structure de conduit d'air selon la revendication 8, dans laquelle une surface de la paroi externe du capot de ventilateur (2) et/ou une surface de la plaque pare-éclaboussures (6) pour former le passage de guidage de flux (41) est pourvue d'une structure d'absorption (8) pour réduire une vitesse du vent.

10. Structure de conduit d'air selon la revendication 1, dans laquelle le nombre de l'orifice d'entrée d'air (3) est de quatre, et les quatre orifices d'entrée d'air (3) sont configurés pour être disposés sur quatre surfaces latérales de l'armoire électrique extérieure (7), respectivement.

11. Structure de conduit d'air selon la revendication 1, dans laquelle la cavité de guidage de flux (4) présente une zone de flux d'air à grande vitesse et une zone de flux d'air à basse vitesse ; une plaque de guidage de flux (42) est disposée à une position, correspondant à l'orifice d'entrée d'air (3), de la cavité de guidage de flux (4), et la plaque de guidage de flux (42) est configurée pour guider le flux d'air dans la zone de flux d'air à grande vitesse vers la zone de flux d'air à basse vitesse.

12. Armoire électrique extérieure, comprenant une structure de conduit d'air, dans laquelle la structure de conduit d'air est la structure de conduit d'air selon l'une quelconque des revendications 1 à 11.
